(19) Europäisches Patentamt
European Patent Office
Office européen des brevets

(11) EP 2 374 847 A1

(12) **EUROPEAN PATENT APPLICATION**

(43) Date of publication:
**12.10.2011 Bulletin 2011/41**

(21) Application number: **11161451.7**

(22) Date of filing: **07.04.2011**

(51) Int Cl.:
***C08L 83/04*** *(2006.01)*
***C08J 5/18*** *(2006.01)*
***H01L 51/52*** *(2006.01)*
***H01L 33/56*** *(2010.01)*
***H01L 33/52*** *(2010.01)*
*C08G 77/12* *(2006.01)*
*C08G 77/20* *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **08.04.2010 JP 2010089425**

(71) Applicant: **Nitto Denko Corporation**
**Ibaraki-shi, Osaka (JP)**

(72) Inventor: **Katayama, Hiroyuki**
**Ibaraki-shi Osaka (JP)**

(74) Representative: **Grünecker, Kinkeldey, Stockmair & Schwanhäusser**
**Anwaltssozietät**
**Leopoldstrasse 4**
**80802 München (DE)**

(54) **Silicone resin sheet**

(57) The present invention relates to a silicone resin sheet obtained by semi- curing a composition including: (1) an organopolysiloxane having at least two alkenylsilyl groups in one molecule thereof; (2) an organopolysiloxane having at least two hydrosilyl groups in one molecule thereof; (3) a hydrosilylation catalyst; and (4) a curing retardant.

EP 2 374 847 A1

## Description

FIELD OF THE INVENTION

The present invention relates to a silicone resin sheet. More particularly, the invention relates to a silicone resin sheet in a semi-cured state obtained from an addition curing type silicone resin composition, a method for producing the sheet, and an optical-semiconductor device encapsulated with the sheet.

BACKGROUND OF THE INVENTION

High-power white LED devices whose application to generic illumination has been studied demand encapsulation materials having light resistance and heat resistance. In recent years, so-called "addition curing type silicone" has been heavily used. The addition curing type silicone is obtained by thermal curing of a mixture mainly composed of a silicone derivative having vinyl groups on a main chain thereof and a silicone derivative having hydrosilyl groups (SiH groups) on a main chain thereof in the presence of a platinum catalyst. For example, the silicone is disclosed in Patent Documents 1 to 3.

As a method for encapsulating an LED element using such an addition curing type silicone, since the addition curing type silicone is liquid before curing, a "potting" method is preferred, wherein a resin is filled into a cup in which an LED element has been placed.

However, in such a method, at the production of a chip array module having a large number of LED elements disposed on a substrate, the module being recently the mainstream, unevenness in height of an encapsulating resin takes place owing to liquid sagging and hence optical properties of the resulting LED device become insufficient. Moreover, there is a problem that the resin before curing is prone to change in viscosity depending on surrounding environment and thus productivity is poor since potting conditions are not stable.

For solving the problem, there is proposed a method for encapsulating an LED element by using a resin in a sheet shape. For example, there are disclosed an encapsulating sheet obtained from an ethylene-vinyl acetate polymer and a polyurethane in Patent Document 4 and an encapsulating sheet obtained from a crosslinkable thermoplastic resin composed of an ethylene-(meth)acrylate copolymer in Patent Document 5. In addition, Patent Document 6 discloses an encapsulating sheet obtained from a thermosetting silicone resin and a thermoplastic silicone resin.

Patent Document 1: JP-A-2000-198930
Patent Document 2: JP-A-2004-186168
Patent Document 3: JP-A-2008-150437
Patent Document 4: JP-A-2007-123452
Patent Document 5: Japanese Patent No. 4383768
Patent Document 6: JP-A-2009-84511

SUMMARY OF THE INVENTION

However, since the organic groups causing a crosslinking reaction are insufficient in light resistance and heat resistance, the conventional resin sheets are still unsatisfactory as encapsulating materials for high-power LED elements.

An object of the invention is to provide a silicone resin sheet in a semi-cured state, which is excellent in light resistance and heat resistance, a method for producing the sheet, and an optical-semiconductor device encapsulated with the sheet.

Namely, the present invention relates to the following items 1 to 7.

1. A silicone resin sheet obtained by semi-curing a composition for a silicone resin, the composition including:

    (1) an organopolysiloxane having at least two alkenylsilyl groups in one molecule thereof;
    (2) an organopolysiloxane having at least two hydrosilyl groups in one molecule thereof;
    (3) a hydrosilylation catalyst; and
    (4) a curing retardant.

2. The silicone resin sheet according to item 1, in which the (4) curing retardant is at least one compound selected from the group consisting of acetylenic compounds and olefinic compounds.
3. The silicone resin sheet according to item 2, in which the (4) curing retardant is at least one selected from the group consisting of 1-ethynylcyclohexanol and 1,3,5,7-tetravinyl-1,3,5,7-tetramethylcyclotetrasiloxane.

4. The silicone resin sheet according to any one of items 1 to 3, in which the (4) curing retardant is contained in an amount of from $1.0 \times 10^2$ to $1.0 \times 10^6$ parts by weight based on 100 parts by weight of the (3) hydrosilylation catalyst.
5. The silicone resin sheet according to any one of items 1 to 4, which has a hardness of 0.1 to 10.
6. A method for producing a silicone resin sheet in a semi-cured state, the method including:

applying a composition for a silicone resin into a sheet shape, followed by thermal curing at 40 to 150°C for 0.1 to 120 minutes, the composition including:

(1) an organopolysiloxane having at least two alkenylsilyl groups in one molecule thereof;
(2) an organopolysiloxane having at least two hydrosilyl groups in one molecule thereof;
(3) a hydrosilylation catalyst; and
(4) a curing retardant.

7. An optical-semiconductor device obtained by encapsulating an optical-semiconductor element using the silicone resin sheet according to any one of items 1 to 5.

Since the silicone resin sheet of the invention is excellent in light resistance and heat resistance, the sheet exhibits an excellent effect of being able to perform encapsulation of high-power LED elements satisfactorily.

## DETAILED DESCRIPTION OF THE INVENTION

The silicone resin sheet of the invention is a sheet obtained by semi-curing a composition for a silicone resin, the composition including (1) an organopolysiloxane having at least two alkenylsilyl groups in one molecule thereof; (2) an organopolysiloxane having at least two hydrosilyl groups in one molecule thereof; (3) a hydrosilylation catalyst; and (4) a curing retardant. The sheet has a significant characteristic that curing of the addition curing type silicone resin is controlled and thus cured in a semi-cured state by using the curing retardant.
A highly active platinum catalyst is generally used in an addition curing type silicone resin. Accordingly, when a curing reaction once starts, it is extremely difficult to stop the reaction halfway. It is therefore difficult to form a semi-cured state (stage B). Then, it has been known that addition of a phosphorus compound, a nitrogen compound, a sulfur compound or an acetylene as a reaction inhibitor is effective, in order to decrease the catalytic activity of the platinum catalyst. However, since the compounds known as the reaction inhibitors influence durability of the resin, the semi-cured state is formed in the invention by controlling the curing reaction of the addition curing type silicone resin by using a curing retardant. Also, the curing retardant does not influence stability of the resin, so that a satisfactory stability can be secured even after encapsulation.

### (1) Organopolysiloxane Having at least Two Alkenylsilyl Groups in One Molecule Thereof

In the invention, from the viewpoint of forming crosslinking, as a constituting monomer of the resin, an organopolysiloxane having at least two alkenylsilyl groups in one molecule thereof (hereinafter also referred to as organopolysiloxane A) is used.
The alkenylsilyl group is a group where an alkenyl group is bonded to a silicon atom. The alkenyl group may be disposed in any position of a molecular end, a main chain, and a side chain.
The alkenyl group represents a substituted or unsubstituted alkenyl group and may be linear, branched or cyclic one as long as it is an organic group containing an alkenyl group in a framework thereof. From the viewpoints of transparency and heat resistance, the carbon number of the organic group is preferably from 1 to 20, and more preferably from 1 to 10. Specifically, there are exemplified a vinyl group, an allyl group, a propenyl group, a butenyl group, a pentenyl group, a hexenyl group, a heptenyl group, an octenyl group, a norbornenyl group, a cyclohexenyl group and the like. Above all, a vinyl group is preferred from the viewpoint of reactivity to the hydrosilylation reaction.
There is no particular limitation on the organic groups bonded to the silicon atom other than the alkenyl group. For example, monovalent hydrocarbon groups may be mentioned.
The monovalent hydrocarbon groups include saturated or unsaturated, linear, branched or cyclic hydrocarbon groups. The carbon number of the hydrocarbon group is preferably from 1 to 20, and more preferably from 1 to 10, from the viewpoints of transparency and heat resistance. Specifically, there are exemplified a methyl group, an ethyl group, a propyl group, a butyl group, a pentyl group, a hexyl group, a phenyl group, a naphthyl group, a cyclohexyl group, a cyclopentyl group and the like. Above all, a methyl group is preferred from the viewpoints of transparency, heat resistance and light resistance of the resulting resin composition.
Specific examples of the organopolysiloxane A include linear, vinyl-ended polydimethylsiloxanes, vinyl-ended dimethylsiloxane-diphenylsiloxane copolymers, vinyl-ended poly(methyl)(phenyl)siloxanes, vinyl-ended dimethylsiloxane-diethylsiloxane copolyemrs, trimethylsiloxy-ended dimethylsiloxane-methyl(vinyl)siloxane copolyemrs, silanol-ended dimethylsiloxane-methyl(vinyl)siloxane copolyemrs, vinyl-ended dimethylsiloxane-methyl(vinyl)siloxane copolyemrs, and trimethylsiloxy-ended poly(methyl)(vinyl)siloxanes, as well as cyclic compounds, branched compound and three-dimensional reticular compounds thereof. These can be used either alone or as a combination of two or more thereof.

The above compounds may be commercially available ones or may be ones synthesized according to known methods.

The alkenylsilyl functional group equivalent of the organopolysiloxane A is preferably from 0.005 to 10 mmol/g, and more preferably from 0.010 to 5 mmol/g, from the viewpoints of toughness and flexibility of the cured material. When the equivalent is 0.005 mmol/g or more, a sufficient strength is exhibited, whereas when it is 10 mmol/g or less, a satisfactory flexibility is exhibited. In the present specification, the functional group equivalent of the silicone derivative can be measured by a method described in Examples to be mentioned later.

Moreover, the viscosity of the organopolysiloxane A at 25°C is preferably from 100 to 500,000 mPa·s, and more preferably 300 to 100,000 mPa·s, form the viewpoint of toughness of the cured material. In the specification, the viscosity can be measured by using a B-type viscometer.

The content of the organopolysiloxane A is preferably from 0.1 to 99.9% by weight, and more preferably from 1 to 99% by weight in the composition for a silicone resin in the invention.

(2) Organopolysiloxane Having at least Two Hydrosilyl Groups in One Molecule Thereof

In the invention, from the viewpoint of forming crosslinking, as a constituting monomer of the resin, an organopolysiloxane having at least two hydrosilyl groups in one molecule thereof (hereinafter also referred to as organopolysiloxane B) is used.

The hydrosilyl group is a group where a hydrogen atom is bonded to a silicon atom. The group may be disposed in any position of a molecular end, a main chain, and a side chain.

There is no particular limitation on the organic groups bonded to the silicon atom other than the hydrogen atom. For example, monovalent hydrocarbon groups may be mentioned.

As the monovalent hydrocarbon groups, those the same as the monovalent hydrocarbon groups in the above organopolysiloxane A may be exemplified. Above all, a methyl group is preferred from the viewpoints of transparency, heat resistance, and light resistance of the resulting resin composition.

Specific examples of the organopolysiloxane B include linear, dimethylsilyl-ended polydimethylsiloxanes, dimethylsilyl-ended dimethylsiloxane-diphenylsiloxane copolymers, dimethylsilyl-ended poly(methyl)(phenyl)siloxanes, dimethylsilyl-ended dimethylsiloxane-diethylsiloxane copolyemrs, trimethylsiloxy-ended dimethylsiloxane-methyl(hydro) siloxane copolyemrs, and trimethylsiloxy-ended poly(methyl)(hydro)siloxanes, as well as cyclic compounds, branched compound and three-dimensional reticular compounds thereof. These can be used either alone or as a combination of two or more thereof.

The above compounds may be commercially available ones or may be ones synthesized according to known methods.

The hydrosilyl functional group equivalent of the organopolysiloxane B is preferably from 0.005 to 10 mmol/g, and more preferably from 0.010 to 5 mmol/g, from the viewpoints of toughness and flexibility of the cured material. When the equivalent is 0.005 mmol/g or more, a sufficient strength is exhibited, whereas when it is 10 mmol/g or less, a satisfactory flexibility is exhibited.

Moreover, the viscosity of the organopolysiloxane B at 25°C is preferably from 100 to 500,000 mPa·s, and more preferably 300 to 100,000 mPa·s, form the viewpoint of toughness of the cured material.

The content of the organopolysiloxane B is preferably from 0.1 to 99.9% by weight, and more preferably from 1 to 99% by weight in the composition for a silicone resin in the invention.

Moreover, the content of the organopolysiloxane B is preferably from 0.1 to 1,000 parts by weight, and more preferably from 1 to 100 parts by weight based on 100 parts by weight of the organopolysiloxane A, from the viewpoint of toughness of the cured material.

Moreover, in the composition for a silicone resin in the invention, the weight ratio of the organopolysiloxane A to the organopolysiloxane B is preferably adjusted so that the molar ratio of the above functional groups (alkenylsilyl group/hydrosilyl group) becomes preferably from 1/50 to 50/1, and more preferably from 1/5 to 5/1, from the viewpoint of allowing the alkenylsilyl group of the organopolysiloxane A and the hydrosilyl group of the organopolysiloxane B to react with each other in just proportion.

(3) Hydrosilylation Catalyst

There is no particular limitation on the hydrosilylation catalyst in the invention, as long as it is a compound catalyzing the hydrosilylation reaction between the alkenylsilyl group and the hydrosilyl group. There are exemplified

platinum catalysts such as platinum black, platinum chloride, chloroplatinic acid, a platinum-olefin complex, a platinum-carbonyl complex, and platinum-acetyl acetate; palladium catalysts; rhodium catalysts and the like. Above all, a platinum-olefin complex such as a platinum-divinyltetramethyldisiloxane is preferred from the viewpoints of compatibility, transparency and catalytic activity.

With regard to the content of the hydrosilylation catalyst, for example, in the case of using a platinum catalyst, the platinum content is preferably from $1.0\times10^{-4}$ to 0.5 part by weight, and more preferably from $1.0\times10^{-3}$ to 0.05 part by weight based on 100 parts by weight of the organopolysiloxane A, from the viewpoint of the curing rate.

(4) Curing Retardant

There is no particular limitation on the curing retardant in the invention, as long as it is a compound having a curing-inhibiting effect on the hydrosilylation catalyst. Examples thereof include acetylenic compounds, olefinic compounds, phosphorus-based compounds, nitrogen-based compounds, sulfur-based compounds, and organic peroxides. For example, there are exemplified acetylenic compounds such as 1-ethynylcyclohexanol and 3-methyl-1-butyn-3-ol, olefinic compounds such as 1,3,5,7-tetravinyl-1,3,5,7-tetramethylcyclotetrasiloxane and dimethyl maleate, phosphorus-based compounds such as triphenylphosphine, nitrogen-based compounds such as tributylamine, tetramethylethylenediamine, imidazole, and benzotriazole, sulfur-based compounds such as benzothiazole, and organic peroxides. Above all, from the viewpoints of heat resistance, light resistance, and curing-inhibiting effect, acetylenic compounds and olefinic compounds are preferred, and 1-ethynylcyclohexanol and 1,3,5,7-tetravinyl-1,3,5,7-tetramethylcyclotetrasiloxane are more preferred.

The content of the curing retardant is preferably from $1.0\times10^{2}$ to $1.0\times10^{6}$ parts by weight, and more preferably from $1.0\times10^{3}$ to $1.0\times10^{5}$ parts by weight based on 100 parts by weight of the hydrosilylation catalyst. When the content thereof is $1.0\times10^{2}$ parts by weight or more, a sufficient curing-inhibiting effect is obtained and change in hardness is small even when the resulting cured material is stored. When the content thereof is $1.0\times10^{6}$ parts by weight or less, curing is not exceedingly retarded and also heat resistance of the cured material does not decrease. Namely, the site such as acetylene or olefin in the curing retardant forms a coordination bond or the like with the hydrosilylation catalyst such as the platinum catalyst to decrease the catalytic activity, so that the curing reaction is retarded.

The composition for a silicone resin in the invention can contain other arbitrary components, in addition to the above, within the range not impairing the effects of the invention. For example, there are exemplified inorganic fillers such as silica, titanium oxide, zirconium oxide, magnesium oxide, zinc oxide, iron oxide, aluminum hydroxide, calcium carbonate, layered mica, carbon black, diatomaceous earth, glass fiber, and oxide, nitride, and oxynitride fluorescent materials activated with a lanthanoid element, as well as those obtained by surface-treatment of these fillers with an organosilicon compound such as an organoalkoxysilane, an organochlorosilane, or an organosilazane. The content of the filler is preferably from 1 to 100 parts by weight, and more preferably from 1 to 50 parts by weight based on 100 parts by weight of the organopolysiloxane A.

Incidentally, the composition may contain additives such as an antioxidant, a modifying agent, a surfactant, a dye, a pigment, a discoloration preventing agent, an ultraviolet absorber, a creep hardening preventing agent, a plasticizer, a thixotropy-imparting agent, and a fungicide.

The silicone resin sheet of the invention can be prepared by preparing a composition for a silicone resin by stirring the above-mentioned components (1) to (4) and, if necessary, a filler and the like preferably at 0 to 60°C for 1 to 120 minutes, and forming the resulting composition into a sheet shape. Specifically, the above-mentioned composition is applied, for example, onto a release sheet (for example, an organic polymer film such as a polyester substrate, a ceramic, a metal, or the like) whose surface is release treated to an appropriate thickness by a method such as casting, spin coating or roll coating, and dried by heating, thereby being able to form the composition into the sheet shape. Incidentally, the hydrosilylation reaction partially proceeds through the above-mentioned heating, and the resulting sheet is transformed into a semi-cured state (B stage).

The heating temperature is preferably from 20 to 200°C, and more preferably from 40 to 150°C. The heating time is preferably from 0.1 to 120 minutes, and more preferably from 1 to 60 minutes.

The thickness of the silicone resin sheet is not particularly limited but is preferably from 100 to 10,000 μm, and more preferably 100 to 3,000 μm.

With regard to the silicone resin sheet of the invention, hardness thereof is preferably from 0.1 to 10, and more preferably from 0.1 to 5, from the viewpoint of being able to encapsulate optical-semiconductor elements en bloc by using the sheet. Accordingly, the invention also provides a silicone resin sheet having a hardness of 0.1 to 10 and being obtained by applying the composition for a silicone resin containing the above-mentioned components (1) to (4) into a sheet shape, followed by thermal curing. Incidentally, in the present specification, the hardness of the silicone resin sheet can be measured by a method described in Examples to be mentioned later.

Moreover, when the silicone resin sheet of the invention has been stored, for example, at 5°C for 24 hours, the hardness of the sheet is preferably from 0.1 to 10, and more preferably from 0.1 to 5.

The invention also provides a method for producing a silicone resin sheet in a semi-cured state, the method including: applying the composition for a silicone resin containing the above-mentioned components (1) to (4) into a sheet shape, followed by thermal curing at 40 to 150°C for 0.1 to 120 minutes. Incidentally, the preparation of the composition for a silicone resin can be performed according to the method described above.
Since the thus-obtained silicone resin sheet is in the semi-cured state, for example, the resin sheet is placed as such on an optical semiconductor element or on a known resin after potting, followed by performing encapsulation processing, and thereafter, the resin sheet is completely cured by heating at high temperature, thereby being able to prepare an optical semiconductor device. Accordingly, the invention provides an optical-semiconductor device obtained by encapsulating an optical-semiconductor element using the silicone resin sheet of the invention.
The complete curing of the silicone resin sheet of the invention is performed by the reaction of the functional group relating to the hydrosilylation reaction, which has remained during the reaction at the preparation of the above-mentioned sheet. The progress degree of the hydrosilylation reaction can be confirmed by the degree of absorption of a peak derived from the hydrosilyl group, according to IR measurement. For example, when the absorption intensity is less than 20% of an initial value (before the curing reaction, i.e., absorption intensity of the sheet before placing), it can be judged that the hydrosilylation reaction is completed and the resin sheet is completely cured.
There is no particular limitation on a method for placing the sheet on the substrate, followed by performing encapsulation processing. For example, there is exemplified a method of pressing the sheet on the substrate by heating preferably at 100 to 200°C and 0.01 to 10 MPa, more preferably at 120 to 180°C and 0.1 to 1 MPa, for 2 to 600 seconds, using a laminator, and then, performing encapsulation processing.
The heating temperature of the encapsulation processing is preferably from 120 to 250°C, and more preferably from 150 to 200°C. The heating time is preferably from 0.5 to 48 hours, and more preferably from 1 to 24 hours.

EXAMPLES

The invention will be described below with reference to examples and comparative examples, but is not construed as being limited thereto.

[Average Molecular Weight of Silicone Derivative]

The molecular weight of each of the silicone derivatives is determined in terms of polystyrene by gel filtration chromatography (GPC).

[Functional group equivalent of Silicone Derivative]

The functional group equivalent is measured by $^1$H-NMR using an internal standard substance.

[Viscosity of Silicone Derivative and Composition]

The viscosity is measured by using a rheometer (B type rheometer) under conditions of 25°C and 1 atm.

[Average Particle Diameter of Filler]

The average particle diameter of a filler means an average particle diameter of primary particles of the filler. Diameters of 100 particles displayed in a screen were measured and an average value thereof is taken as the average particle diameter.

Example 1

A composition for a silicone resin was obtained by mixing 20 g (0.71 mmol) of a vinyl-ended polydimethylsiloxane [n=375, vinylsilyl equivalent: 0.071 mmol/g, average molecular weight: 28,000, viscosity (25°C): 1,000 mPa·s] represented by the formula (I):
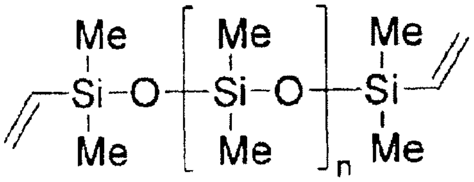 (I)

in which n represents an integer of 1 or more, 0.80 g (0.40 mmol) of a trimethylsiloxy-ended dimethylsiloxane-(methyl)(hydro)siloxane copolymer [x=24, y=2, hydrosilyl equivalent: 0.63 mmol/g, average molecular weight: 2,000, viscosity (25°C): 30 mPa·s] represented by the formula (II):

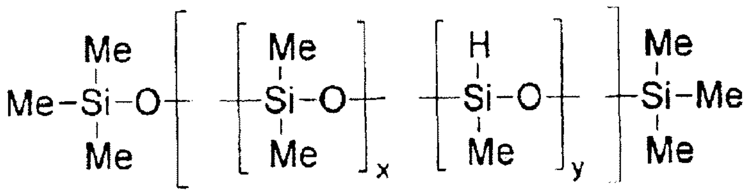 (II)

in which x represents an integer of 1 or more and y represents an integer of 2 or more, 2.5 g of hexamethyldisilazane-treated silica particles (average particle diameter: 20 μm), 0.036 mL of a xylene solution of a platinum-divinyltetramethyldisiloxane complex (platinum concentration: 2% by weight) (the platinum content was 0.0036 part by weight based on 100 parts by weight of the vinyl-ended polydimethylsiloxane), and 0.028 mL (0.081 mmol, 3900 parts by weight based on 100 parts by weight of the platinum-divinyltetramethyldisiloxane complex) of 1,3,5,7-tetravinyl-1,3,5,7-tetramethylcyclotetrasiloxane under stirring at room temperature (20°C) for 10 minutes.

The resulting composition was applied on a biaxially oriented polyester film (manufactured by Mitsubishi Chemical Polyester Film Co., Ltd., 50 μm) to a thickness of 500 μm. Then, the composition was heated under conditions shown in Table 1, thereby obtaining a silicone resin sheet in a semi-cured state (semi-cured material) (thickness: 500 μm).

Example 2

A silicone resin sheet in a semi-cured state (thickness: 500 μm) was obtained in the same manner as in Example 1 except that the hexamethyldisilazane-treated silica particles were not used in Example 1.

Example 3

A silicone resin sheet in a semi-cured state (thickness: 500 μm) was obtained in the same manner as in Example 1 except that 35 g (0.71 mmol) of a vinyl-ended polydimethylsiloxane [n=665, vinylsilyl equivalent: 0.040 mmol/g, average molecular weight: 49,500, viscosity (25°C): 5,000 mPa·s] represented by the formula (I) was used instead of the use of 20 g (0.71 mmol) of the vinyl-ended polydimethylsiloxane [n=375, vinylsilyl equivalent: 0.071 mmol/g, average molecular weight: 28,000, viscosity (25°C): 1,000 mPa·s] represented by the formula (I) in Example 1.

Example 4

A silicone resin sheet in a semi-cured state (thickness: 500 μm) was obtained in the same manner as in Example 1 except that 0.056 mL (0.16 mmol, 7,800 parts by weight based on 100 parts by weight of the platinum-divinyltetramethyldisiloxane complex) of 1,3,5,7-tetravinyl-1,3,5,7-tetramethylcyclotetrasiloxane was used instead of the use of 0.028 mL (0.081 mmol) of 1,3,5,7-tetravinyl-1,3,5,7-tetramethylcyclotetrasiloxane in Example 1.

Example 5

A silicone resin sheet in a semi-cured state (thickness: 500 μm) was obtained in the same manner as in Example 1 except that 0.14 mL (0.41 mmol, 19,400 parts by weight based on 100 parts by weight of the platinum-divinyltetramethyldisiloxane complex) of 1,3,5,7-tetravinyl-1,3,5,7-tetramethylcyclotetrasiloxane was used instead of the use of 0.028 mL (0.081 mmol) of 1,3,5,7-tetravinyl-1,3,5,7-tetramethylcyclotetrasiloxane in Example 1.

Example 6

A silicone resin sheet in a semi-cured state (thickness: 500 μm) was obtained in the same manner as in Example 1 except that 38 mg (0.31 mmol, 5,300 parts by weight based on 100 parts by weight of the platinum-divinyltetramethyldisiloxane complex) of 1-ethynylcyclohexanol was used instead of the use of 0.028 mL (0.081 mmol) of 1,3,5,7-tetravinyl-1,3,5,7-tetramethylcyclotetrasiloxane in Example 1.

Comparative Example 1

A silicone resin sheet in a semi-cured state (thickness: 500 μm) was obtained in the same manner as in Example 1 except that 1,3,5,7-tetravinyl-1,3,5,7-tetramethylcyclotetrasiloxane was not used in Example 1.

Using the silicone resin sheets in a semi-cured state obtained above, completely cured materials and optical semiconductor devices were prepared according to the following method.

Preparation Example 1 of Completely Cured material

The silicone resin sheets in a semi-cured state were heated at 150°C for 5 hours, thereby preparing completely cured silicone resin sheets.

Preparation Example 1 of Optical Semiconductor Device

A substrate on which a blue LED was mounted was coated with each of the silicone resin sheets in a semi-cured state which had been stored at 5°C for 24 hours, followed by heating under reduced pressure at 160°C for 5 minutes and pressing at a pressure of 0.2 MPa. The resulting device was heated at 150°C for 5 hours, thereby preparing an optical semiconductor device.

For the semi-cured materials, completely cured materials and optical semiconductor devices obtained above, characteristics were evaluated according to the following Test Examples 1 to 6. The results thereof are shown in Table 1.

Test Example 1 (Hardness)

When a load of 7 g/mm$^2$ was applied to the semi-cured material and the completely cured material immediately after the preparation by a sensor head using a digital length measuring meter (MS-5C, manufactured by Nikon Corporation), the distance the sensor head sank from a surface of the sheet was measured, and the sheet hardness was determined based on the following equation. Incidentally, the larger value of the sheet hardness shows that the sheet is harder.

$$\text{Sheet hardness} = [1 - (\text{the distance } (\mu m) \text{ the sensor head sank/the film thickness } (\mu m) \text{ of the sample})] \times 100$$

Test Example 2 (Storage Stability)

For each of the semi-cured material immediately after the preparation and after the storage at 5°C for 24 hours, the sheet hardness was determined in the same manner as in Test Example 1. Then, the ratio of the resulting sheet hardness [(after the storage/immediately after the preparation)×100] was calculated as hardness retention (%), and storage stability was evaluated according to the following evaluation criteria. The smaller value of the hardness retention shows the more excellent storage stability in a semi-cured state.

[Evaluation Criteria of Storage Stability]

A: the hardness retention was 100% or more and 200% or less.

B: the hardness retention was more than 200% and 900% or less.
C: the hardness retention was more than 900%.

Test Example 3 (Light Transmittance)

The light transmittance (%) of each completely cured material at a wavelength of 450 nm was measured by using a spectrophotometer (U-4100, manufactured by Hitachi High-Technologies Corporation). The higher light transmittance shows the more excellent light transmitting property.

Test Example 4 (Heat Resistance)

Each completely cured material was allowed to stand still in a hot air type dryer of 150°C, and appearance of the completely cured material after an elapse of 100 hours was visually observed. The case where no change in color from a state before storage was observed was evaluated as "A", and the case where a change in color was observed was evaluated as "B". No change in appearance after storage shows that the material is excellent in heat resistance.

Test Example 5 (Encapsulation Property)

States of each semiconductor device before and after encapsulation were observed under an optical microscope. The case where the semiconductor element was completely embedded, no deformation and damage were observed, and the element was lighted was evaluated as "A", and the case where the element was not lighted was evaluated as "B".

Test Example 6 (Light Resistance)

An electric current of 300 mA was applied to each semiconductor device to light an LED element, and the luminance thereof immediately after the test was started was measured with an instantaneous multiple photometric system (MCPD-3000, manufactured by Otsuka Electronics Co., Ltd.). Then, the LED element was allowed to stand in a state where it was lighted, and the luminance after an elapse of 300 hours was similarly measured. The luminance retention was calculated by the following equation, and the light resistance was evaluated. The higher luminance retention shows the more excellent light resistance.

Luminance retention (%) = (luminance after elapse of 300 hours/luminance immediately after the test was started) × 100

Table 1

| | | | Example 1 | Example 2 | Example 3 | Example 4 | Example 5 | Example 6 | Comparative Example 1 |
|---|---|---|---|---|---|---|---|---|---|
| | (1) Vinyl-Ended Polydimethylsiloxane | n in Formula (I) | 375 | 375 | 665 | 375 | 375 | 375 | 375 |
| | | Vinylsilyl Equivalent (mmol/g) | 0.071 | 0.071 | 0.040 | 0.071 | 0.071 | 0.071 | 0.071 |
| | | Average Molecular Weight | 28000 | 28000 | 49500 | 28000 | 28000 | 28000 | 28000 |
| | | Viscosity (25°C, mPa·s) | 1000 | 1000 | 5000 | 1000 | 1000 | 1000 | 1000 |
| | | Content (parts by weight) | 100 | 100 | 100 | 100 | 100 | 100 | 100 |

(continued)

| | | | Example 1 | Example 2 | Example 3 | Example 4 | Example 5 | Example 6 | Comparative Example 1 |
|---|---|---|---|---|---|---|---|---|---|
| Composition | (2) Trimethylsiloxy-Ended Dimethylsiloxane-(Methyl)(hydro)siloxane Copolymer | x in Formula (II) | 24 | 24 | 24 | 24 | 24 | 24 | 24 |
| | | y in Formula (II) | 2 | 2 | 2 | 2 | 2 | 2 | 2 |
| | | Hydrosilyl Equivalent (mmol/g) | 0.63 | 0.63 | 0.63 | 0.63 | 0.63 | 0.63 | 0.63 |
| | | Average Molecular Weight | 2000 | 2000 | 2000 | 2000 | 2000 | 2000 | 2000 |
| | | Viscosity (25°C, mPa·s) | 30 | 30 | 30 | 30 | 30 | 30 | 30 |
| | | Content (part by weight)[1)] | 4 | 4 | 2.3 | 4 | 4 | 4 | 4 |
| | (3) Platinum-Divinyltetramethyldisiloxane Complex | Content (part by weight)[2)] | 0.0036 | 0.0036 | 0.0036 | 0.0036 | 0.0036 | 0.0036 | 0.0036 |
| | (4) Curing Retardant | Kind | VM cyclo-tetra-siloxane | VM cyclo-tetra-siloxane | VM cyclo-tetra-siloxane | VM cyclo-tetra-siloxane | VM cyclo-tetra-siloxane | 1-ethynyl-cyclo-hexanol | --- |
| | | Content (parts by weight)[3)] | 3900 | 3900 | 3900 | 7800 | 19400 | 5300 | --- |
| | Hexamethyldisi lazane-Treated Silica Particles | Content (parts by weight)[1)] | 12.5 | 0 | 12.5 | 12.5 | 12.5 | 12.5 | 12.5 |
| | Vinylsilyl Group/Hydrosilyl Group[4)] | | 2.8 | 2.8 | 2.8 | 2.8 | 2.8 | 2.8 | 2.8 |

(continued)

| | | Example 1 | Example 2 | Example 3 | Example 4 | Example 5 | Example 6 | Comparative Example 1 |
|---|---|---|---|---|---|---|---|---|
| Before Curing | Viscosity (25°C, mPa·s) | 1300 | 1000 | 5200 | 1300 | 1300 | 1300 | 1300 |
| Semi-Cured material | Curing Conditions | 80°C, 6 minutes | 80°C, 8 minutes | 80°C, 8 minutes | 80°C, 9 minutes | 80°C, 18 minutes | 80°C, 7 minutes | 80°C, 3 minutes |
| | Hardness Immediately after Preparation | 1.1 | 1.5 | 1.2 | 1.3 | 1.5 | 2.0 | 2.0 |
| | Hardness after Storage | 9.4 | 9.0 | 8.8 | 6.0 | 2.7 | 7.8 | 20 |
| | Storage Stability | B | B | B | B | A | B | C |
| Completely Cured Material | Hardness Immediately after Preparation | 80.1 | 75.8 | 65.9 | 71.9 | 56.6 | 79.4 | 85.0 |
| | Light Transmitting Property (Light Transmittance, %) | 95 | 99 | 94 | 94 | 95 | 95 | 95 |
| | Heat Resistance | A | A | A | A | A | A | A |
| Optical-Semiconductor Device | Encapsulation Property | A | A | A | A | A | A | B |
| | Light Resistance (Luminance Retention, %) | 99.8 | 99.9 | 99.6 | 99.5 | 99.8 | 99.6 | --- |

* VM cyclotetrasiloxane: 1,3,5,7-tetravinyl-1,3,5,7-tetramethylcyclotetrasiloxane
1) The content shows the content (parts by weight) based on 100 parts by weight of the vinyl-ended polydimethylsiloxane.
2) The content shows the platinum content (part by weight) based on 100 parts by weight of the vinyl-ended polydimethylsiloxane.
3) The content shows the content (parts by weight) based on 100 parts by weight of platinum-divinyltetramethyldisiloxane.
4) The ratio shows the molar ratio [{vinylsilyl equivalent × content of (1)}/{hydrosilyl equivalent × content of (2)} of the vinylsilyl group of (1) vinyl-ended polydimethylsiloxane and the hydrosilyl group of (2) trimethylsiloxy-ended dimethylsiloxane-(methyl)(hydro)siloxane copolymer.

As a result, all the silicone resin sheets of Examples are excellent in storage stability of the semi-cured materials and are satisfactory in heat resistance and light resistance, irrespective of the presence of silica particles and the kind of the curing retardant, and even the sheets after storage at 5°C show little change in hardness and are capable of performing encapsulation, so that it can be said that the sheets have a sufficient performance as an LED encapsulating material. In addition, there is suggested a tendency that the curing rate decreases and the storage stability increases as the mixing amount of the curing retardant increases. On the other hand, in the silicone resin sheet of Comparative Example 1 where no curing retardant was used, storage stability of the semi-cured material was poor and, when an LED was encapsulated by using the sheet after storage at 5°C for 24 hours, bonding wires were remarkably distorted to bring about a short, so that the LED was not lighted.

While the invention has been described in detail with reference to specific embodiments thereof, it will be apparent to one skilled in the art that various changes and modifications can be made therein without departing from the spirit and scope thereof.
Incidentally, the present application is based on Japanese Patent Application No. 2010-089425 filed on April 8, 2010, and the contents are incorporated herein by reference.
All references cited herein are incorporated by reference herein in their entirety.
Also, all the references cited herein are incorporated as a whole.

The silicone resin sheet of the invention can be suitably used, for example, at the time of producing semiconductor elements of backlights of liquid crystal screens, traffic signals, outdoor large-sized displays, advertising signs and the like.

## Claims

**1.** A silicone resin sheet obtained by semi-curing a composition for a silicone resin, said composition comprising:

(1) an organopolysiloxane having at least two alkenylsilyl groups in one molecule thereof;
(2) an organopolysiloxane having at least two hydrosilyl groups in one molecule thereof;
(3) a hydrosilylation catalyst; and
(4) a curing retardant.

**2.** The silicone resin sheet according to claim 1, wherein the (4) curing retardant is at least one compound selected from the group consisting of acetylenic compounds and olefinic compounds.

**3.** The silicone resin sheet according to claim 2, wherein the (4) curing retardant is at least one selected from the group consisting of 1-ethynylcyclohexanol and 1,3,5,7-tetravinyl-1,3,5,7-tetramethylcyclotetrasiloxane.

**4.** The silicone resin sheet according to any one of claims 1 to 3, wherein the (4) curing retardant is contained in an amount of from $1.0\times10^2$ to $1.0\times10^6$ parts by weight based on 100 parts by weight of the (3) hydrosilylation catalyst.

**5.** The silicone resin sheet according to any one of claims 1 to 4, which has a hardness of 0.1 to 10.

**6.** A method for producing a silicone resin sheet in a semi-cured state, said method comprising:

applying a composition for a silicone resin into a sheet shape, followed by thermal curing at 40 to 150°C for 0.1 to 120 minutes, said composition comprising:

(1) an organopolysiloxane having at least two alkenylsilyl groups in one molecule thereof;
(2) an organopolysiloxane having at least two hydrosilyl groups in one molecule thereof;
(3) a hydrosilylation catalyst; and
(4) a curing retardant.

**7.** An optical-semiconductor device obtained by encapsulating an optical-semiconductor element using the silicone resin sheet according to any one of claims 1 to 5.

Europäisches Patentamt
European Patent Office
Office européen des brevets

# EUROPEAN SEARCH REPORT

Application Number
EP 11 16 1451

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/308828 A1 (KASHIWAGI TSUTOMU [JP] ET AL) 18 December 2008 (2008-12-18)<br>* example 1 *<br>* page 8, paragraphs 87,88,91-93 *<br>* page 9, left-hand column, lines 1-18 * | 1-7 | INV.<br>C08L83/04<br>C08J5/18<br>H01L51/52<br>H01L33/56<br>H01L33/52<br><br>ADD.<br>C08G77/12<br>C08G77/20 |
| X<br>A | US 2003/129347 A1 (YAMAKAWA KIMIO [JP] ET AL) 10 July 2003 (2003-07-10)<br>* example 1 * | 1-6<br>7 | |
| X<br>A | US 6 304 000 B1 (ISSHIKI MINORU [JP] ET AL) 16 October 2001 (2001-10-16)<br>* example 7 * | 1-6<br>7 | |
| X<br>A | US 2009/146175 A1 (BAHADUR MANEESH [US] ET AL) 11 June 2009 (2009-06-11)<br>* claims 1,15 * | 7<br>1-6 | |
| X<br>A | US 2004/178509 A1 (YOSHINO MASACHIKA [JP] ET AL) 16 September 2004 (2004-09-16)<br>* example 1 *<br>* page 6, paragraph 76 * | 7<br>1-6 | TECHNICAL FIELDS SEARCHED (IPC)<br>C08L<br>C08J<br>H01L<br>C09J<br>C09D |

The present search report has been drawn up for all claims

1

| Place of search | Date of completion of the search | Examiner |
|---|---|---|
| Munich | 13 May 2011 | Barrère, Matthieu |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 11 16 1451

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2011

| Patent document cited in search report | Publication date | Patent family member(s) | Publication date |
|---|---|---|---|
| US 2008308828 A1 | 18-12-2008 | EP 1980591 A1 | 15-10-2008 |
| | | JP 2009235368 A | 15-10-2009 |
| | | KR 20080092272 A | 15-10-2008 |
| US 2003129347 A1 | 10-07-2003 | NONE | |
| US 6304000 B1 | 16-10-2001 | NONE | |
| US 2009146175 A1 | 11-06-2009 | CN 101356214 A | 28-01-2009 |
| | | EP 1973963 A1 | 01-10-2008 |
| | | JP 2009523856 T | 25-06-2009 |
| | | KR 20080089400 A | 06-10-2008 |
| | | WO 2007086987 A1 | 02-08-2007 |
| US 2004178509 A1 | 16-09-2004 | JP 2010174250 A | 12-08-2010 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000198930 A
- JP 2004186168 A
- JP 2008150437 A
- JP 2007123452 A
- JP 4383768 B
- JP 2009084511 A
- JP 2010089425 A